# EUROPÄISCHE PATENTANMELDUNG

(11) **EP 0 984 247 A2**
(43) Veröffentlichungstag der Anmeldung: **08.03.2000**
(21) Anmeldenummer: 99117232.1
(22) Anmeldetag: 02.09.1999
(51) Int. Cl.: G01D 5/20

(54) **Induktiver Sensor**

(30) Priorität: 05.09.1998 DE 19840665
(71) Anmelder: Matthias Oechsler & Sohn GmbH & Co., 91522 Ansbach (DE)
(72) Erfinder:

(57) **Zusammenfassung**

Ein preiswert in Serie herstellbarer und thermisch ebenso wie dynamisch hoch beanspruchbarer Läufer für einen kleinbauenden, direkt oder inkremental messenden induktiven Sensor ergibt sich, wenn durch Heißprägen aus einer dicken Metallfolie heraus die im geheizten Klischee vorgegebene Geometrie der Induktions-Stromschleife direkt auf die - auch unebene - Oberfläche eines thermoplastischen Leitungsträgers gestanzt und im gleichen Zuge mit diesem verschweißt wird.

## Beschreibung

Die Erfindung betrifft einen Sensor gemäß dem Oberbegriff des Hauptanspruches.

Zum Aufbau induktiver Sensoren der hier betrachteten Art mit ihren verdrehbaren oder linear verschiebbaren Läufern ist etwa aus der DE 21 58 713 C3 = US 38 12 481 A eine gedruckte Leiterplatte für die Ausbildung einer induktiv gespeisten Stromschleife bekannt, mit der ein apparativ leichter und verschleißfrei da berührungslos, völlig temperaturunabhängig präzise winkel- oder weg-abhängig arbeitender Impulsgeber für ein inkrementales Meßsystem erstellt werden kann, wie es etwa im rauhen Kraftfahrzeugbetrieb zur Drosselklappensteuerung oder zur Niveauregelung einsetzbar ist, vgl. ferner DE 40 08 199 A1. Auch Servogeber zur direkten induktiven Winkelstellungsübertragung (vgl. EP 0 143 852 A1) lassen sich in parallelen Ebenen aus Läufer mit (periodisch umlaufender oder zur Spule ergänzter) Leiterschleife und Stator mit mehreren (gegeneinander verschwenkt orientierten) Spulen aufbauen, zwischen denen je nach der Läuferstellung eine unterschiedliche Kopplung besteht.

Problematisch ist eine kostengünstige aber durch die Umfeldgegebenheiten im praktischen Einsatz dynamisch und thermisch hoch beanspruchbare Ausbildung der in solchen Systemen geometrisch sehr präzise anzuordnenden Leiterschleifen, die nicht nur als Signalgeber auszulegen sind, sondern als im elektrischen Kurzschluß betriebene Induktionsschleifen auch einen relativ starken Stromfluß zulassen müssen.

Ein Einsatz der etwa aus der DE 21 58 713 C3 bekannten Technologie der sogenannten gedruckten Schaltung mit ihrer aus einer Leiterplatten-Kaschierung herausgeätzten Leiter-schleifen-Geometrie wäre aber für eine preisgünstige Massenfertigung untragbar teuer, schon wegen des dafür erforderlichen Aufwandes an umweltbelastender Galvanik.

Das bloße Verkleben einer vorgefertigten Leiterbahnstruktur für die Stromschleife auf einem Leitungsträger - etwa gemäß DE-PS 808 052 mittels eines erwärmten, gemäß dem Verlauf der Leiterbahn erhabenen Prägewerkzeugs zum Aufpressen der aus einer klebstoffbeschichteten Blattmetallfolie dabei gleichzeitig herauszutrennenden Leiterbahn oder gemäß DE-OS 22 01 680 mittels zweier Messer zum Ausschneiden der Leiterbahn aus einer auf den Träger aufgeklebten elektrisch leitenden Schicht - kommt schon deshalb nicht in Betracht, weil solche reinen flächigen Klebeverbindungen über den in der Praxis geforderten Temperaturbereich von -40°C bis +120°C nicht schälfest genug sind.

Das aus dem Elektroapparatebau bekannte Einlegen und Verstemmen von thermisch und elektrisch hoch belastbaren, zuvor ausgestanzten Metallgittern in entsprechend verlaufende Rinnen oder auf abgestufte Zapfen, die beim Spritzguß eines thermoplastischen Trägers freigespart wurden, garantiert wegen des unvermeidlichen Spiels des separat eingelegten Metallgitters nicht den für meßtechnische Zwecke erforderlichen geometrisch exakten Verlauf der Leiterschleife beim derart zusammengebauten Läufer und ist auch wegen der für den mehrteiligen Zusammenbau zu lösenden logistischen Bereitstellungsprobleme fertigungstechnisch von Nachteil. Denn zur Herstellung des Metallgitters werden eigens ein Stanzwerkzeug und ein zusätzlicher Arbeitsplatz benötigt, und das manuelle oder automatische Einlegen des Metallgitters benötigt vergleichsweise lange Zeit. An der geforderten Präzision mangelt es erst recht, wenn das Metallgitter erst unmittelbar auf dem Träger ausgestanzt und dabei nicht nur in das Trägermaterial eingepreßt sondern auch noch durchgewölbt federnd längsseits darin verspannt wird, wie es in der DE-PS 596 830 schon vor über 60 Jahren beschrieben wurde. Die gravierenden Nachteile sind schließlich auch nicht dadurch überwindbar, daß ein hochpräzise vorgefertigtes Metallgitter als Insert unmittelbar in die Spritzgußform eingelegt und direkt mit dem Material des Trägers umspritzt wird. Zusätzlich wäre hier zu berücksichtigen, daß der mit ca. 800 bar sehr hohe Innendruck in der Form die exakte geometrische Maßhaltigkeit des in die Form eingelegten Leiterbahnenverlaufes beeinträchtigen, also die Prozeßsicherheit gefährden könnte.

Fertigungstechnisch vorteilhafter wäre dann schon der 2-Schuß-Spritzguß, bei dem zunächst aus isolierendem Grundmaterial der Träger gegossen und ohne Umsetzerfordernisse in dessen Oberfläche dann gemäß dem Verlauf der Stromschleife ein metallisierbares Material eingespritzt wird. Letzteres wäre aber dann noch, um zum elektrischen Leiter für vergleichsweise große impulsförmige Kurzschlußströme zu werden, auf seiner Oberfläche galvanisch zu behandeln, was wiederum zu teuer und wegen der besonderen Umweltschutzerfordernisse zusätzlich aufwendig sein würde.

In Erkenntnis dieser Gegebenheiten liegt vorliegender Erfindung die technische Problematik zugrunde, einen kleinen, auch für extreme Umweltbeanspruchungen geeigneten aber preisgünstig fertigbaren Sensor-Läufer mit sehr definierter Leiterstreifen-Geometrie zur Verfügung zu stellen, wobei der Träger auf seiner die Stromschleife tragenden Fläche nicht unbedingt eben sein muß, sondern auch dreidimensional ausgestaltet sein kann, wie etwa im Falle der Schalenstrukturen der schon erwähnten DE 40 08 199 A1.

Diese Aufgabe ist bei vorliegender Erfindung durch die Merkmale des Hauptanspruches gelöst. Danach findet eine spezifische Modifikation des aus der Kunststofftechnologie - zur Kaschierung von Oberflächen mit dünnen dekorativ oder informativ bedruckten Folien - als solchen bekannten Heißprägeverfahrens Anwendung; nun aber mit einer dagegen dicken, zur Führung auch relativ beträchtlicher Induktionsströme ausreichenden Metallfolie, die unter Zwischenlage einer Kleberschicht mittels eines beheizten Metallklischees von einer der Träger-Oberfläche angepaßten Topographie und zugleich mit einer dem Verlauf der Stromschleife entsprechenden Geometrie eben in jene Oberfläche eingeprägt wird. Dabei wird das am Klischee vorgegebene Leiterbild der Stromschleife maßgenau übertragen, nämlich in als solcher bekannter Weise aus der Folie ausgestanzt, nun aber dabei in einen spritzgegossenen thermoplastischen Träger eingeschweißt. Dieses Aufbringen der Stromschleife wird noch dadurch gesichert, daß das heiße Einprägen in die Oberfläche des Leitungsträgers zu einem seitlichen Aufwölben des erwärmten und lokal verdrängten Materials des Trägers mit der Folge des Aufwerfens eines längs beider Seitenränder der Stromschleife verlaufend leicht überwölbenden Wulstes führt. Das Einsenken geschieht also nur sehr geringfügig, nämlich um im Interesse der Präzision der Leiterschleife deren vom Klischee bestimmte Oberfläche nicht beim Einsenken in das Trägermaterial zu verformen - wie es nach der oben schon zitierten DE-PS 596 830 Voraussetzung für das unter mittiger Hochwölbung seitliche elastische Verspannen gegenüber Grabenrändern war.

Zusätzliche Einzelheiten, Weiterbildungen und Vorteile der erfindungsgemäßen Lösungen ergeben sich aus den weiteren Ansprüchen und aus nachfolgender Beschreibung eines unter Beschränkung auf das Wesentliche stark abstrahiert und nicht maßstabsgerecht skizzierten bevorzugten Realisierungsbeispieles zur Erfindung. In der Zeichnung zeigt :

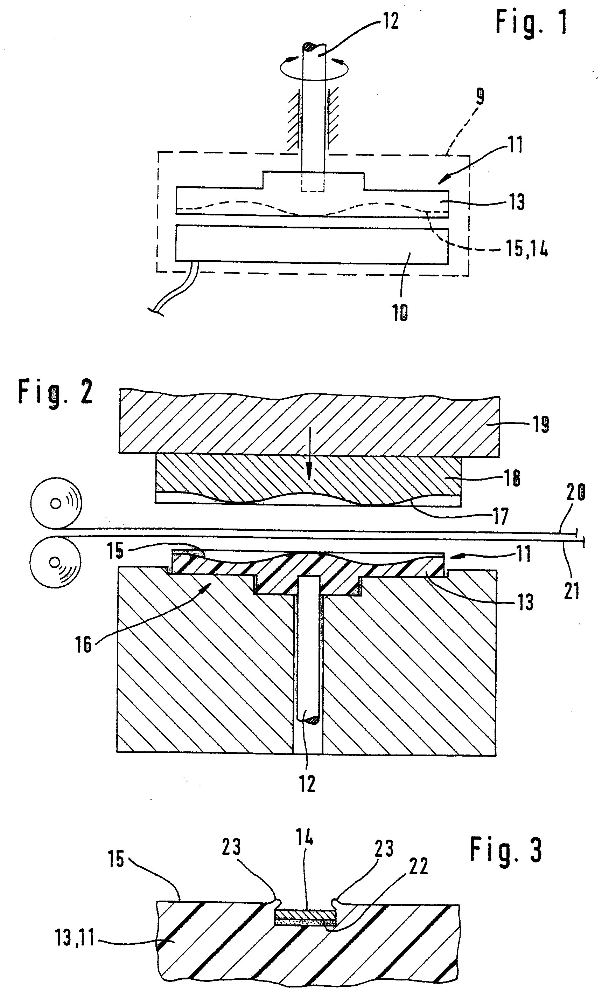

Fig.1 einen induktiven Sensor mit verdrehbarem Läufer in Ansicht,
Fig.2 einen apparativen Aufbau zum Aufbringen einer Stromschleife auf einen Läufer im Schnitt und
Fig.3 im dagegen vergrößerten Querschnitts-Ausschnitt die in ihren Leitungsträger eingebettete Stromschleife.

Der in der Zeichnung skizzierte induktive Sensor 9 mit vor seinem Stator 10 rotationsbeweglich angeordnetem Läufer 11 weist bei diesem eine metallene Welle 12 auf, die in einen aus Polyamid oder dergleichen thermoplastischem Material bestehenden kreisscheibenförmigen Leitungsträger 13 für eine Stromschleife 14 eingespritzt ist. Der Läufer 11 ruht für das Aufbringen der Stromschleife 14 mit frei vorragender Oberfläche 15 des Leitungsträgers 13 großflächig abgestützt in einer ihm geometrisch angepaßten Werkstück-Auflage 16. Jene Oberfläche 15 sei im dargestellten Beispielsfalle nicht eben sondern uneben profiliert, und die Oberfläche 17 eines metallenen Stanz-Klischees 18 weist dann eine komplementäre Topographie auf. Das in diesem Beispiel dreidimensionale Klischee 18, das unter gutem thermischem Kontakt austauschbar unter einen beheizten Stempel 19 montiert ist, gibt also exakt den (hier dreidimensionalen) Verlauf der auf den Leitungsträger 13 aufzubringenden Stromschleife 14 wieder.

Zwischen den noch zueinander distanzierten Oberflächen 15 - 17 von Leitungsträger 13 und Klischee 18 hindurch verläuft nicht die übliche dünne Heißprägefolie aus Kunststoff zur bloßen Oberflächen-Kaschierung; sondern es findet eine relativ dicke (in der Größenordnung von 35 µ messende) elektrisch leitfähige Folie in Form einer Kupferfolienbahn 20 Anwendung, und parallel dazu, zwischen dieser und der Träger-Oberfläche 15, eine Klebermaterialbahn 21. Letztere braucht nicht wie exemplarisch dargestellt als eigenständige Materialbahn zugeführt zu werden, sie kann auch direkt als Kleberschicht 22 auf die dem Leitungsträger 13 zugewandten Oberfläche der Kupferfolienbahn 20 aufkaschiert sein.

Aus dieser Bahn 20 wird die exakte Geometrie des Verlaufes z.B. einer in sich geschlossenen Induktions-Stromschleife 14 von der entsprechend konfigurierten Klischee-Oberfläche 17 ausgestanzt, während die Bahnen 20, 21 auf die Träger-Oberfläche 15 aufgedrückt und unter Erwärmung auf typisch etwa 225°C - vom Stempel 19 her über das Klischee 18 - mit erschmolzener Kleberschicht 22 in die Träger-Oberfläche 15 eingeprägt, also bis geringfügig unter die Oberfläche 15 des Leitungsträgers 13 eingesenkt werden. Dabei wird das unter der Stromschleife 14 gelegene erwärmte Material des Leitungsträgers 13 etwas zu beiden Seiten verdrängt, was dazu führt, daß es sich vor dem seitlich benachbarten, nicht so stark erwärmten und deshalb festeren Material staut und neben den Seitenrändern der Stromschleife 14 nach oben gedrückt wird, wo es den Verlauf dieser Ränder als kleiner Wulst 23 formschlüssig übergreift.

Die so aus dem duktilen Kupfer ausgetrennte Stromschleife 14 schmiegt sich dabei ohne Rißerscheinungen vollflächig an den Verlauf der übereinanderliegenden Oberflächen 15/17 an und verbindet sich über ihre ganze vollflächige Länge innig mit dem Leitungsträger 13, abgesehen von der Einfassung durch die schmalen Wülste 23 vor allem kraftschlüssig zugfest in dessen Oberfläche 15 eingeschweißt. Wenn auf nicht zu unterschiedliche Temperaturausdehnungskoeffizienten für den thermoplastischen Leitungsträger 13 und für die metallische Stromschleife 14 geachtet wird, weshalb etwa die Auswahl eines handelsüblichen glasfaserverstärkten wärmestabilisierten Polyamids einer kleberbeschichteten Kupferfolie zugeordnet wird, dann treten selbst bei ganz extremen mechanischen Beanspruchungen und selbst bei gleichzeitig extremen Schock-Temperaturwechseln noch keine Ablösungserscheinungen vom Träger 13 und nicht einmal Haarrisse in der Stromschleife 14 auf

So ergibt sich ein preiswert in Serie herstellbarer und thermisch ebenso wie dynamisch hoch beanspruchbarer transitorischer oder rotatorischen Läufer 11 für einen kleinbauenden, direkt oder inkremental messenden induktiven Sensor 9, wenn durch Heißprägen aus einer dicken Metallfolie, bevorzugt aus einer Kupferfolienbahn 20 heraus die im geheizten Klischee 18 vorgegebene Geometrie der Induktions-Stromschleife 14 direkt auf die - auch unebene - Oberfläche 15 eines thermoplastischen Leitungsträgers 13 gestanzt und im gleichen Zuge mit diesem verschweißt wird.

## Patentansprüche

1. Induktiver Sensor (9) mit einem relativ zu einem Stator (10) beweglichen Läufer (11) und mit einem elektrisch isolierenden Leitungsträger (13) für eine Stromschleife (14) auf dem Läufer (11), *dadurch gekennzeichnet*, daß eine aus einer, im Vergleich zur Materialstärke von Heißprägefolien, dicken duktilen Kupferfolienbahn (20) ausgestanzte Stromschleife (14) unter Zwischenlage einer Klebermaterialbahn (21) in die Oberfläche (15) eines Spritzguß-Leitungsträgers (13) aus glasfaserverstärktem Polyamid eingeprägt ist.

2. Sensor nach Anspruch 1, *dadurch gekennzeichnet*, daß die Stromschleife (14) so geringfügig in die Oberfläche (15) des Leitungsträgers (13) eingesenkt ist, daß sie gerade längs ihrer Berandung von schmalen Wülsten (23) aus beim Einschweißen lokal verdrängtem Material des Leitungsträgers (13) formschlüssig übergriffen ist.

3. Sensor nach Anspruch 1 oder 2, *dadurch gekennzeichnet*, daß die Oberfläche seines Leitungsträgers (13) uneben profiliert ist und die Stromschleife (14) dieser Topographie angeschmiegt ist.
